(19) Europäisches Patentamt
European Patent Office
Office européen des brevets

(11) EP 0 949 660 B1

## (12) EUROPEAN PATENT SPECIFICATION

(45) Date of publication and mention of the grant of the patent:
**01.08.2007** **Bulletin 2007/31**

(51) Int Cl.:
*H01L 21/00* [(2006.01)]   *H01L 21/68* [(2006.01)]
*G03F 9/00* [(2006.01)]

(21) Application number: **98307955.9**

(22) Date of filing: **30.09.1998**

(54) **Apparatus and method for assembling semiconductor device**

Vorrichtung und Verfahren zum Zusammenbau einer Halbleiteranordnung

Appareil et méthode pour l'assemblage de dispositif semiconducteur

(84) Designated Contracting States:
**DE FR GB**

(30) Priority: **07.04.1998 JP 9495198**

(43) Date of publication of application:
**13.10.1999 Bulletin 1999/41**

(73) Proprietor: **FUJITSU LIMITED**
**Kawasaki-shi,**
**Kanagawa 211-8588 (JP)**

(72) Inventors:
 • **Nakamura, Yutaka,**
  **c/o Fujitsu Limited**
  **Kawasaki-shi,**
  **Kanagawa 211-8588 (JP)**
 • **Koezuka, Tetsuo,**
  **c/o Fujitsu Limited**
  **Kawasaki-shi,**
  **Kanagawa 211-8588 (JP)**

 • **Komoriya, Hitoshi,**
  **c/o Fujitsu Limited**
  **Kawasaki-shi,**
  **Kanagawa 211-8588 (JP)**
 • **Hirahara, Takao,**
  **c/o Fujitsu Limited**
  **Kawasaki-shi,**
  **Kanagawa 211-8588 (JP)**

(74) Representative: **Hitching, Peter Matthew et al**
  **Haseltine Lake**
  **Lincoln House**
  **300 High Holborn**
  **London WC1V 7JH (GB)**

(56) References cited:
  **DE-A- 2 225 011     US-A- 3 903 363**
  **US-A- 4 880 309**

**Description**

The present invention relates to an apparatus and method of assembling a semiconductor device, including positioning and fixing a semiconductor element to a substrate.

Many semiconductor devices have been used in which a semiconductor element such as a photodiode or a laser diode is fixed to a substrate. To obtain such a semiconductor device, it is necessary to position and fix the semiconductor element at a certain position relative to the substrate. In a previously-considered method of assembling a semiconductor device, positioning marks are provided in the substrate, the semiconductor element is moved onto the substrate, and the semiconductor element is positioned relative to the substrate by moving the semiconductor element in such a manner that the bottom of a side of the semiconductor element is overlaid on the positioning marks.

Such a previously-considered method however, has the drawbacks that when the semiconductor element comes near to a target position, the positioning marks are hidden by the semiconductor element and cannot be seen, so it is difficult to achieve the positioning of the semiconductor element with good accuracy in a short time. If the positioning mark is displaced to a position in front of the target position of the semiconductor element, the positioning mark can be easily seen but the positioning of the semiconductor element cannot be accurately attained.

Moreover, the bottom surface of the semiconductor element is not always in intimate contact with the surface of the substrate, and it is necessary to perform the positioning of the semiconductor element in a state where there is a gap between the bottom surface of the semiconductor element and the surface of the substrate. Thus, when the positioning of the semiconductor element is performed while observing the semiconductor element and the substrate, both the bottom surface of the semiconductor element and the surface of the substrate are not in focus, so it is difficult to position the semiconductor element by simultaneously observing both the substrate and the semiconductor element. Furthermore, it is difficult to quickly move the semiconductor element to a target position, so it is not possible to automatically position the semiconductor elements.

A previously-considered apparatus is described in US Patent No. 3,903,363.

It is desirable to provided an apparatus and method of assembling a semiconductor device, by which a semiconductor element can be reliably and quickly positioned relative to a substrate.

According to one aspect of the present invention, there is provided an apparatus for assembling a semiconductor device, comprising:

a stage having a substrate support surface for supporting a substrate;
a support member for carrying a semiconductor element to a position on or near a substrate supported by said stage;
a microscope unit arranged at a first inclination angle of less than 90° with respect to the substrate support surface of said stage;
a counter illuminating unit arranged to an opposite side of a normal to the substrate support surface of said stage to said microscope unit, and arranged at a second inclination angle of less than 90° with respect to the substrate support surface thereof;
a camera arranged at an image forming position of said microscope unit; and
an image processing unit connected to said camera,
characterised in that the microscope unit includes a coaxial illumination unit arranged for illuminating a side surface of a semiconductor element located on a substrate supported by the support surface of the stage, the side surface extending in a direction outwardly from the support surface, the coaxial illumination unit (20) being arranged to output light in a direction coaxial with the microscope unit (22).

With such apparatus, it is possible to acquire an image of a positioning mark provided on the substrate and an image of a reflection of the positioning mark reflected by a side surface of a semiconductor element, to calculate the positional relationship between the semiconductor element and the substrate, and to accurately and quickly position the semiconductor element relative to the substrate.

Preferably, the stage has a heater, so that the semiconductor element can be soldered to the substrate.

Preferably, the substrate has at least one positioning mark. Further, the camera is preferably adapted to acquire an image of at least one positioning mark and an image of a reflection of at least one positioning mark reflected by a side surface of the semiconductor element, to thereby obtain the positional relationship between the image of at least one positioning mark and the image of the reflection of at least one positioning mark. The positioning of the semiconductor element onto the substrate can then be performed according to the positional relationship obtained in this manner.

Preferably, the apparatus for assembling a semiconductor element further comprises: calculating means for calculating a positional relationship between the substrate and the semiconductor element from the positional relationship between the image of at least one positional mark and the image of the reflection thereof; and moving means for moving at least one of the stage and the support member according to the calculating means.

Preferably, at least one positioning mark has a circular shape. Alternatively, at least one positioning mark may have a specific shape formed in the substrate. Alternatively, at least one positioning mark may be formed from a material, which is different in reflectance from a material of the aforesaid substrate.

Preferably, the substrate has two positioning marks. Further, the substrate desirably has a linear structure which is different from the at least one positioning mark.

A method for assembling a semiconductor element comprises the steps of: acquiring an image of at least one positioning mark formed on a substrate, which is supported on a stage, and an image of a reflection of at least one positioning mark reflected by a side surface of the semiconductor element arranged on or near the substrate; obtaining a positional relationship between the image of at least one positioning mark and the image of the reflection of at least one positioning mark; and positioning the semiconductor element relative to the substrate according to the positional relationship therebetween.

In this case too, the positioning of a semiconductor element relative to a substrate can be accurately and quickly achieved by obtaining an image of a positioning mark provided on the substrate and an image of a reflection of the positioning mark reflected by a side surface of a semiconductor element, and then calculating the positional relationship between the semiconductor element and the substrate.

Preferably, the step of acquiring the image of at least one positioning mark formed on the substrate comprises acquiring the image by a camera through a microscope unit, while slantingly irradiating the substrate with illuminating light from a counter illuminating unit arranged inclined to the substrate support surface of the stage, the microscope unit being arranged on the opposite side of the counter illuminating unit with respect to a normal to the substrate support surface of the stage and inclined to a substrate support surface of the stage.

Preferably, the step of acquiring an image of at least one positioning mark and an image of the reflection of at least one positioning mark reflected by a side surface of the semiconductor element, comprises a step of acquiring the images by a camera through a microscope unit, while slantingly irradiating the substrate with illuminating light from a coaxial illuminating unit provided in the microscope unit.

Preferably, the method further comprises the step of calculating a positional relationship between the substrate and the semiconductor element from the positional relationship between the image of at least one positioning mark and the image of the reflection of at least one positioning mark, and moving at least one of the stage and the support member supporting the semiconductor element, according the result of the calculation. Preferably, the method further comprises the step of computing a distance between the substrate and the semiconductor element and an angle of rotation of the semiconductor element with respect to the substrate from at least one positioning mark and the reflection image.

Preferably, the step of acquiring the image of at least one positioning mark and the image of the reflection thereof comprises the steps of: acquiring the images of two positioning marks and the images of reflections thereof; and calculating a distance between the substrate and the semiconductor element, an angle of rotation of the substrate, and an angle of rotation of the semiconductor element with respect to the substrate, which is based on an angle between a straight line, which passes through the two positioning marks formed on the substrate, and a straight line, which passes through reflections of the two positioning marks, from the two positioning marks and reflections thereof. Preferably, the method further comprises the steps of: adjusting a position of the semiconductor element in a direction parallel to a side thereof according to at least one mark provided on the semiconductor element and to a position of at least the one positioning mark provided thereon.

Preferably, the substrate has a linear structure, which is different from the one positioning mark, and a position of the semiconductor element is adjusted by preliminarily checking a positional relationship between the one positioning mark and the linear structure and then adjusting the position of the semiconductor element according to the positional relationship therebetween in a case that at least one positioning mark is hidden by the semiconductor element when the semiconductor element is placed at a target position.

Reference will now be made, by way of example, to the accompanying drawings, in which:

Fig. 1 is a view illustrating an apparatus for assembling a semiconductor device according to the first embodiment of the present invention;
Fig. 2 is a view illustrating the case where the counter illuminating unit is used when no semiconductor element is present on the substrate;
Fig. 3 is a view illustrating a case where the coaxial illuminating unit is used when a semiconductor element is present on the substrate;
Fig. 4 is a view illustrating an example of the substrate provided with a positioning mark;
Fig. 5 is a view illustrating an example of a case where the semiconductor element is placed on the substrate inclined to a side of the substrate;
Fig. 6 is a schematic plan view of the substrate and the semiconductor element;
Fig. 7 is a schematic side view, in cross-section, of the substrate and the semiconductor element;
Fig. 8 is a view illustrating an image of the positioning mark and an image of a reflection thereof, which are obtained by an image processing unit included in the Figure 1 apparatus,

Fig. 9 is an enlarged view of a part of Fig. 8;

Fig. 10 is a view illustrating an example of a case where two positioning marks are arranged on the substrate;

Fig. 11 is a view illustrating an example of a case where two marks respectively constituted by concave parts are provided in a side portion of the substrate;

Fig. 12 is a plan view showing a possible shape of the positioning mark provided on the substrate;

Fig. 13 is a cross-sectional view corresponding to Fig. 12;

Fig. 14 is a perspective view illustrating another possible shape of the positioning mark provided on the substrate;

Figs. 15A to 15C are views illustrating a method of fabricating a semiconductor device according to the second embodiment of the present invention;

Figs. 16A to 16C are views illustrating the steps following the steps of Fig. 15C;

Fig. 17 is a view illustrating an example of a method of recognizing the position of a linear structure;

Fig. 18 is a view illustrating another example of a method of recognizing the position of a linear structure;

Fig. 19 is a view illustrating still another example of a method of recognizing the position of a linear structure; and

Fig. 20 is a view illustrating yet another example of a method of recognizing the position of a linear structure.

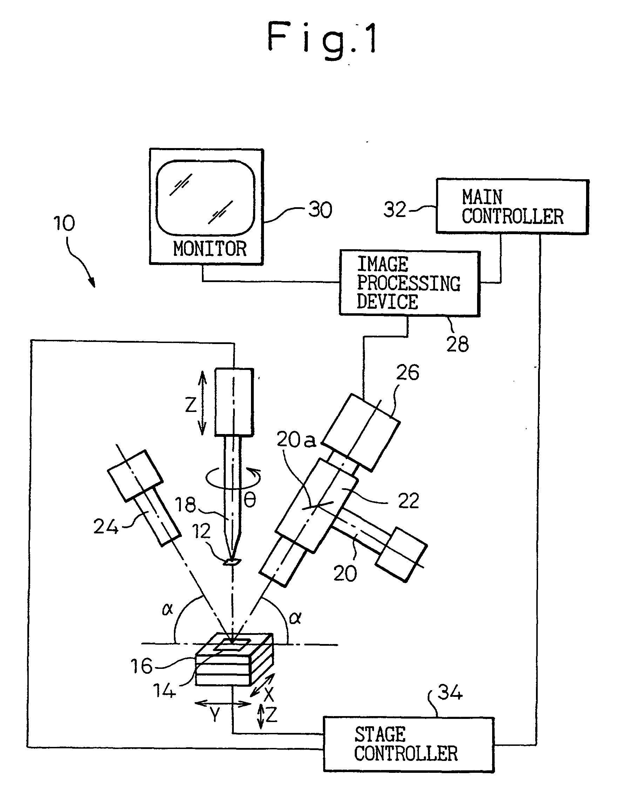

Figure 1 shows an apparatus for assembling a semiconductor device according to the present invention. The apparatus 10 is operative to form a semiconductor device by attaching a semiconductor element 12 to a substrate 14. The semiconductor element 12 is a semiconductor chip such as a photodiode or a laser diode, for example, and the substrate 14 is a silicon substrate, for instance.

The apparatus 10 is provided with a stage 16 onto which the substrate 14 is placed, and a support member 18 for carrying the semiconductor element 12 onto the substrate 14 supported by the stage 16. The stage 16 is adapted to move in the X, Y and Z axes and has a heater (not shown) therein, so that the semiconductor element 12 can be soldered to the substrate 14 by inserting solder between the semiconductor element 12 and the substrate 14. The support member 18 comprises an arm 18 and is movable in the direction of the Z-axis and rotatable in the direction of an angle θ around the Z-axis. Further, the support member 18 has an attracting means, which is operative to attract the semiconductor element 12, at the tip end portion thereof.

The apparatus 10 is further provided with a microscope unit 22 having a coaxial illuminating unit 20, a counter illuminating unit 24, a CCD camera 26 placed at an image forming position of the microscope unit 22, and an image processing unit 28 connected to the CCD camera 26. Moreover, a monitor 30, a main controller 32 and a stage controller 34 are provided in the fabrication apparatus 10. The main controller 32 is operative to control the entire apparatus. The stage controller 34 controls the movement of the stage 16 and the support member 18.

The microscope unit 22 having the coaxial illuminating unit 20 is arranged inclined to the substrate support surface of the stage 16, and the counter illuminating unit 24 is arranged inclined on the opposite side of the microscope unit 22 with respect to a normal N to the substrate support surface of the stage 16 and inclined to the substrate support surface thereof. The microscope unit 22 is arranged at an angle α of elevation to the substrate support surface of the stage 16. The counter illuminating unit 24 is arranged at the reverse side of the microscope unit 22 and at an angle α of elevation to the substrate support surface of the stage 16. The coaxial illuminating unit 20 contains a semitransparent mirror 20a placed in the barrel of the microscope unit 22.

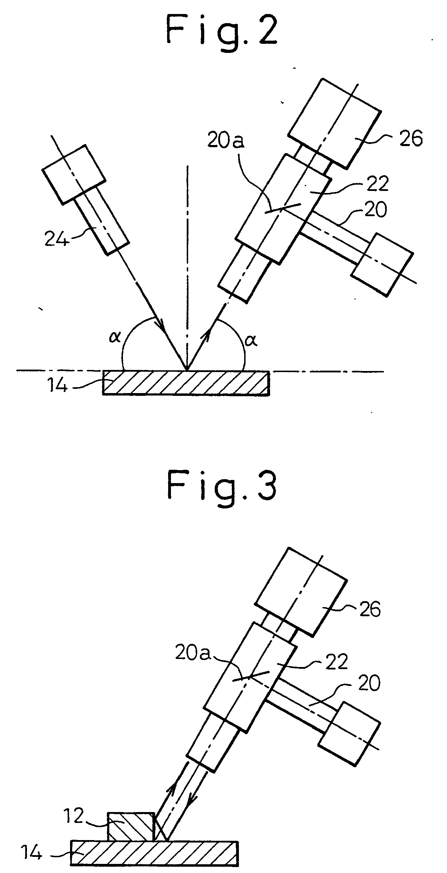

Figure 2 illustrates a case where the counter illuminating unit 24 is used when the semiconductor element 12 is not present on the substrate 14. Illuminating light emitted from the counter illuminating unit 24 is regularly reflected by the surface of the substrate 14 of the stage 16 and is then made incident to the microscope unit 22. The illuminating light then passes through the semitransparent mirror 20a and travels toward the CCD camera 26. Image obtained by the CCD camera 26 is processed by the image processing unit 28.

Figure 3 illustrates a case that the coaxial illuminating unit 20 is used when the semiconductor element 12 is present on the substrate 14. Illuminating light emitted from the coaxial illuminating unit 20 is reflected by the semitransparent mirror 20a and then travels in the barrel of the microscope unit 22 toward the substrate 14 supported by the stage 16. The illuminating light is reflected by the surface of the substrate 14 supported by the stage 16 and by a side surface of the semiconductor element 12 and is made incident to the microscope unit 22. The light passes through the semitransparent mirror 20a and then goes to the CCD camera 26. Image obtained by the CCD camera 26 is processed by the image processing unit 28.

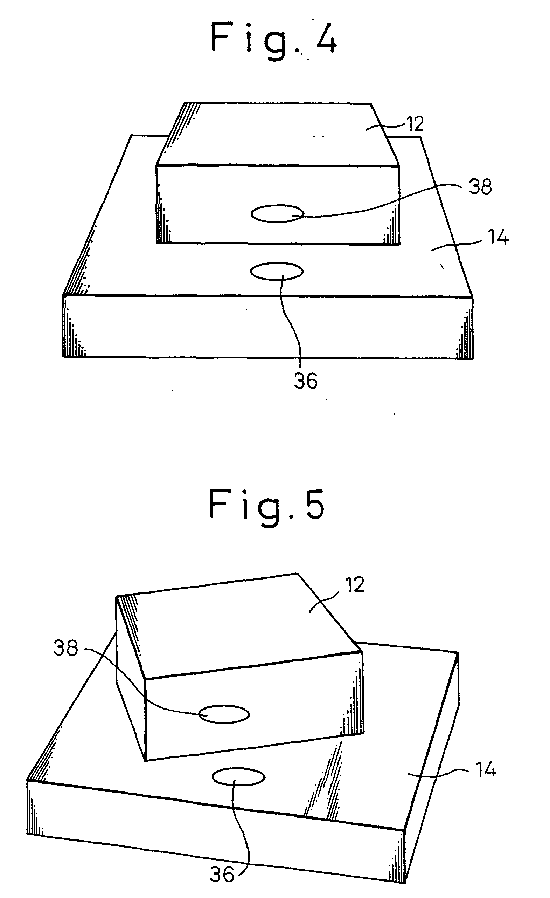

Figure 4 illustrates an example of the substrate 14 having a positioning mark 36. When the substrate 14 and the semiconductor element 12 are viewed in a slanting direction, the positioning mark 36 and a reflection (image) 38 of the positioning mark 36, which is reflected by a side surface of the semiconductor element 12, are observed. Namely, the reflection 38 of the positioning mark 36 is formed on the side surface of the semiconductor element 12 since the cleavage plane of the crystal of the semiconductor element 12 acts as a mirror. Fig. 5 illustrates a case where the semiconductor element 12 is placed on the substrate 14 in such a way as to be inclined at an angle to the substrate 14.

In a fabricating operation, the substrate 14 is put on the stage 16 and then the positioning of the substrate 14 thereon is performed. In this case, the positioning of the substrate 14 is performed while the semiconductor element 12 is not present on or near the substrate 14 as illustrated in Fig. 2, by observing the surface of the substrate 14 by the microscope unit 22, using the counter illuminating unit 24, and obtaining the image of the positioning mark 36 on the substrate 14, using the CCD camera 26.

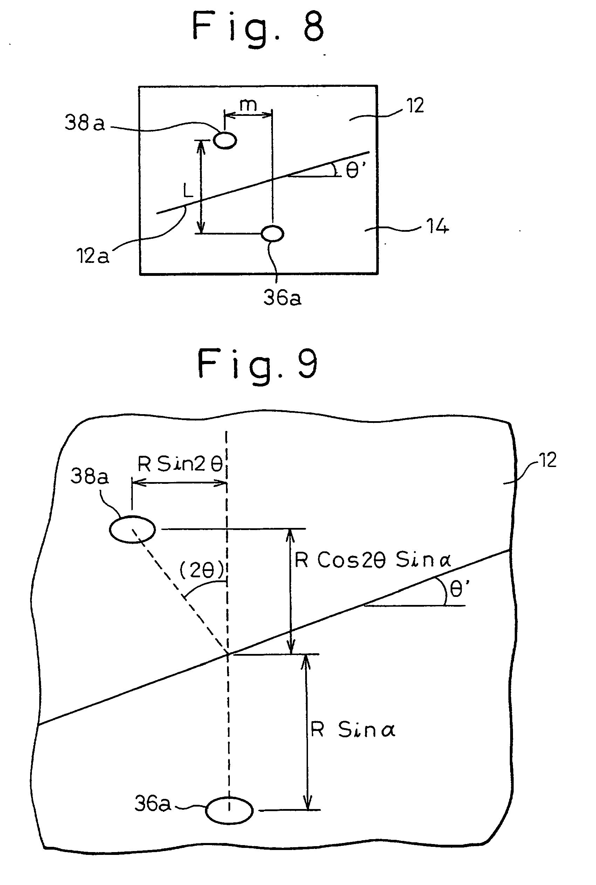

The support member 18 is then operated to move the semiconductor element 12 onto the substrate 14. The coaxial illuminating unit 20 is used this time, as illustrated in Fig. 3. The positioning mark on the surface of the substrate 14 and the reflection 38 of the positioning mark 36 on the side surface of the semiconductor element 12 are observed by the microscope unit 22, and, an image 36a (see Fig. 8) of the positioning mark 36 and an image 38a (see Fig. 8) of the reflection 38 are obtained by the CCD camera 26.

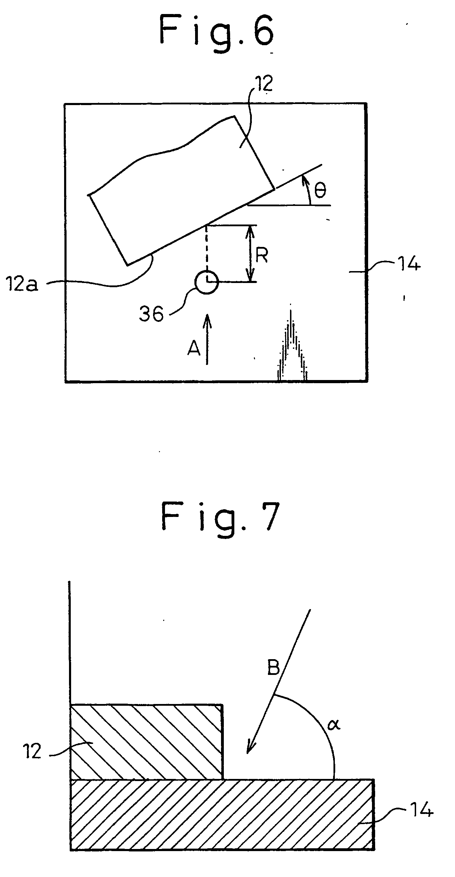

Figure 6 is a plan view of the substrate 14 and the semiconductor element 12. Fig. 7 is a side cross-sectional view of the substrate 14 and the semiconductor element 12. Incidentally, the direction A indicates a direction in which the substrate 14 is seen from the front thereof. In this case, it is assumed that the angle $\theta$ is formed between the substrate 14 and the side surface 12a of the semiconductor 12 and that the distance in the direction A between the positioning mark 36 and the side surface 12a of the semiconductor element 12 is R.

Figures 8 and 9 are views of the substrate 14 and the semiconductor element 12 that are seen from an upwardly slanting direction. Namely, Figs. 8 and 9 show the image 36a of the positioning mark 36 and the image 38a of the reflection 38, which are obtained by the image processing unit 28 (and thus displayed on the screen of the monitor 30) in the case where the microscope unit 22 is placed in the direction A of Fig. 6 and in the direction of Fig. 7. The distance "m" between the image 36a of the positioning mark 36 and the image 38a of the reflection 38 in the direction of the X-axis and the distance "L" therebetween in the direction of the Y-axis can be obtained directly from these images displayed on the screen. Further, the angle $\theta'$ formed between the substrate 14 and the side surface 12a of the semiconductor element 12 can be also obtained directly from the image displayed on the screen. There are the following relationship among the distances "m" and "L" and the angle $\theta'$, which are illustrated in Figs. 8 and 9, and the distance "R" and the angle $\theta$ that are illustrated in Fig. 6.

$$m = Rsin2\theta \qquad (1)$$

$$L = R(1 + cos2\theta)sin\alpha \qquad (2)$$

$$\theta' = arcTan(sin\theta sin\alpha/cos\theta) \qquad (3)$$

These equations are solved for R and $\theta$ as follows:

$$R = (L + m^2 sin^2\alpha/L)(2sin\alpha) \qquad (4)$$

$$\theta = arcTan(msin\alpha/L) \qquad (5)$$

These relationships are stored in the main controller 32. Thus, R and $\theta$ can be immediately obtained by obtaining m, L and $\theta'$ by image processing. Therefore, it is possible to position the semiconductor element 12 as desired by moving or adjusting the semiconductor element 12 in the direction A of Fig. 6 by a predetermined distance with respect to the substrate 14 and by turning it by an angle $\theta$. Incidentally, the aforementioned calculation is an example of the positioning of the semiconductor element in the XY-plane to be performed when the semiconductor element 12 is in contact with the substrate 14.

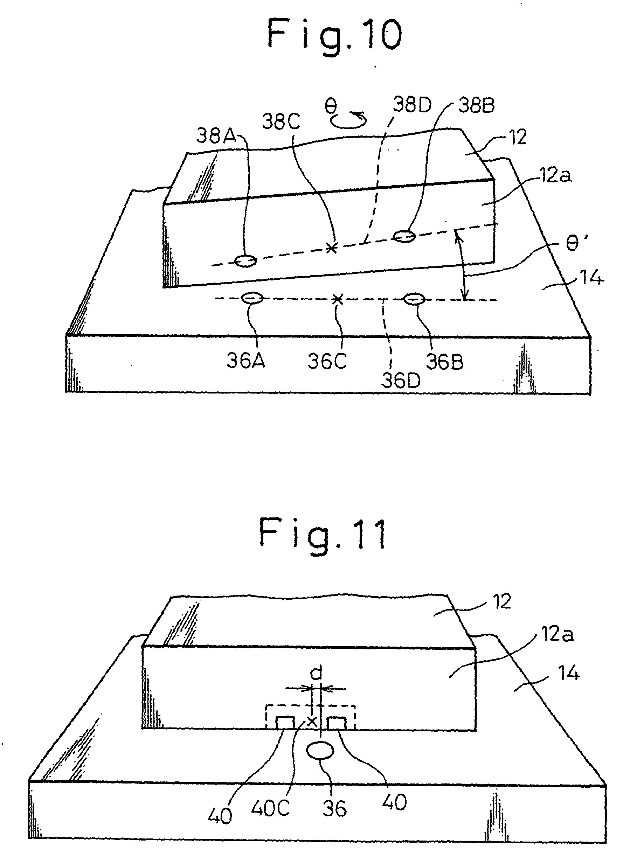

In the case where it is necessary to perform the positioning of the semiconductor element 12 in the direction perpendicular to the direction A, suitable marks should be provided on the side surface 12a of the semiconductor element 12. For instance, Fig. 11 shows an example in which two marks 40 respectively constituted by concave portions are provided in the side surface (portion) 12a of the semiconductor element 12. The positioning of the semiconductor element 12 in the direction perpendicular to the direction A can be achieved by obtaining the distance "d" from the midpoint 40c between the two marks 40 to the positioning mark 36. Further, the positioning of the semiconductor element 12 in the XY-plane can be performed with the semiconductor element 12 placed above the substrate 14 at a slight gap between the semiconductor element 12 and the substrate 14.

Upon completion of the positioning of the semiconductor element 12 relative to the substrate 14, the heater provided in the stage 16 is operated to solder the semiconductor element 12 to the substrate 14. The solder may be preliminarily provided on the surface of the substrate 14, or alternatively, the solder may be filled into a space between the semiconductor element 12 and the substrate 14.

Figure 10 shows an example in which two positioning marks 38A and 38B are provided on the substrate 14. The reflection images 38A and 38B of the two positioning marks 36A and 36B are formed or seen in the side surface 12a of the semiconductor element 12. In this example, the midpoint 36C between the positioning marks 36A and 36B, the straight line 36D passing through the positioning marks 36A and 36B, the midpoint 38C between the reflection images 38A and 38B, the straight line 38D passing through the reflection images 38A and 38B can be obtained. The angle θ' of rotation can be obtained from the relationship between the straight lines 36D and 38D. The distance between the semiconductor element 12 and the positioning mark can be obtained from the distance between the midpoints 36C and 38C.

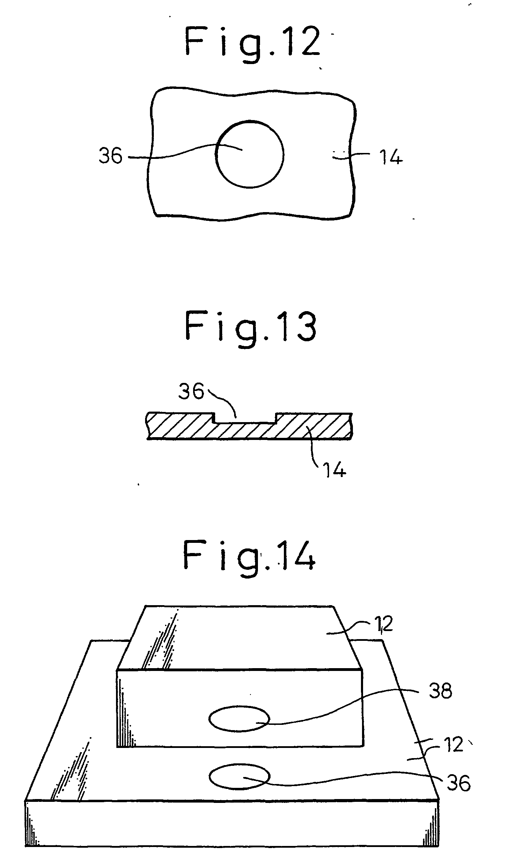

It is preferable that the positioning mark 36 formed on the substrate 14 has a circular shape, as shown in Fig. 12. As a result of shaping the positioning mark 36 in a circle, the observed positioning mark 36 has a same shape, regardless of the angle of rotation of the semiconductor element 12 and the substrate 14. Thus, the recognition of the positioning mark is facilitated.

It is preferable that the positioning mark 36 of the substrate 14 is formed in the substrate 14 in a specific shape, as illustrated in Fig 13. In the example of Fig. 13, the positioning mark is formed in a circular concave shape. Such a positioning mark can be reliably and easily formed by etching the substrate 14. Incidentally, the positioning mark can be formed in a convex shape.

Figure 14 shows another example of the positioning mark 36. In this case, the positioning mark 36 is formed from a material or shape, which is different in reflectance from a material or shape of the substrate 14. Namely, the positioning mark 36 is formed from a material or shape, whose reflectance is higher or lower than that of the substrate 14. Thus, the image of the positioning mark has high contrast, so that the recognition of the positioning mark is facilitated.

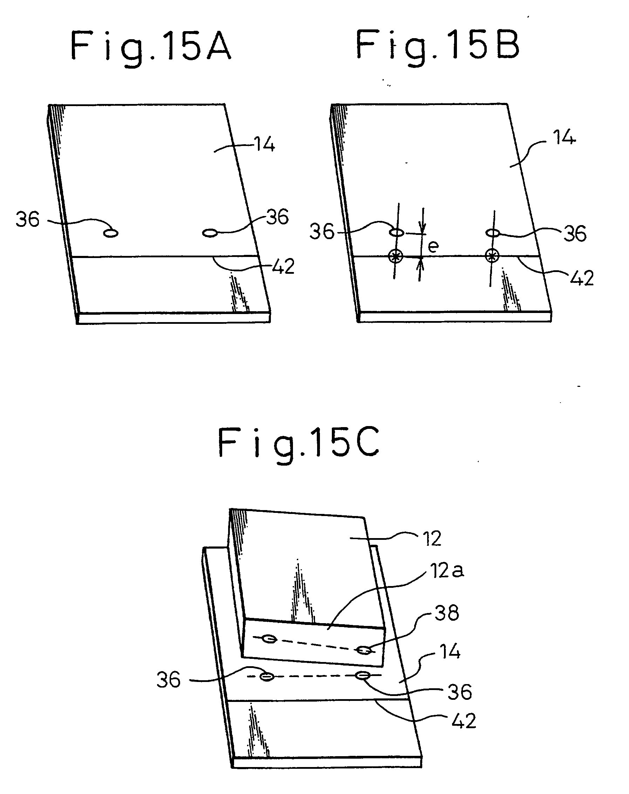

Figs. 15A to 20 show another embodiment of the present invention. In this embodiment too, the semiconductor manufacturing apparatus of Fig. 1 is used. This embodiment is advantageous in a case where the positioning mark 36 is formed on the substrate 14 at such a position that the mark 36 is hidden by the semiconductor element 12. The substrate 14 has a linear structure 42 that is different from the circular positioning mark 36. In this embodiment, the linear structure 42 is formed by utilizing a boundary between surfacial structures of the substrate 14.

When fabricating a semiconductor device, the circular positioning marks 36 formed on the substrate 14 are recognized, as illustrated in Fig. 15A. Moreover, the linear structure 42 provided on the substrate 14 is recognized as illustrated in Fig. 15B. Then, the distance "e" between the circular positioning mark 36 and the linear structure 42 is obtained. Next, the semiconductor element 12 is put on the substrate 14, as illustrated in Fig. 15C. The semiconductor element 12 is temporarily positioned at a position, where the circular positioning marks 36 can be seen, according to the relationship between the image of the circular positioning mark 36 and the reflection image thereof, in a similar manner to the foregoing case. At that time, the rotation of the semiconductor element 12 is corrected.

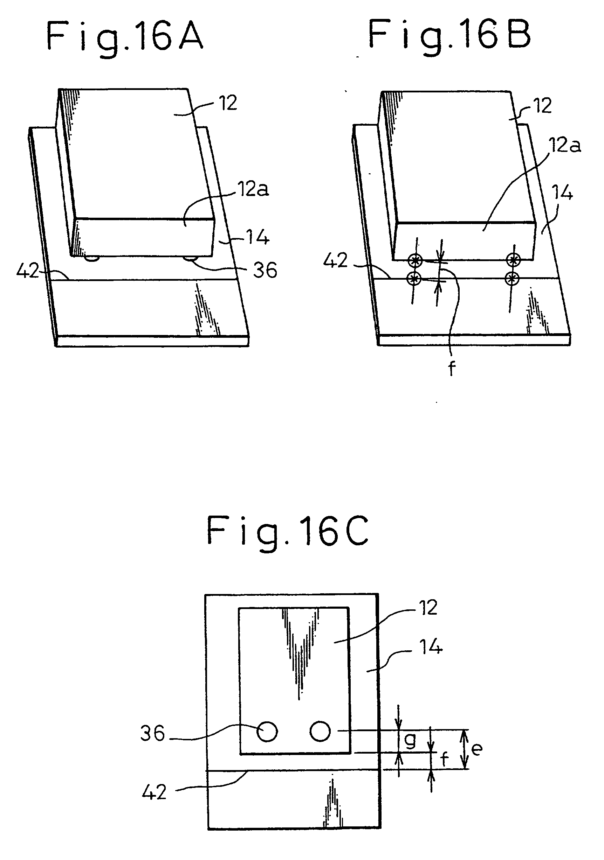

Further, the semiconductor element 12 is moved to a position which is almost a target position, as illustrated in Fig. 16A. At that time, the circular positioning marks 36 are hidden by the semiconductor element 12. Subsequently, the distance "f" between the side surface 12a of the semiconductor element 12 and the linear structure 42, as illustrated in Fig. 16B. Next, the semiconductor element 12 is further moved by a distance g = e - f, as illustrated in Fig. 16C.

In this fabrication method, even when the circular positioning marks 36 are hidden by the semiconductor element 12, the positioning or justification of the semiconductor element 12 can be checked by measuring data representing the positional relationship between each circular positioning mark 36 and the linear structure 42 before the circular positioning marks 36 are hidden and by then adjusting the position of the semiconductor element 12 with respect to this linear structure 42. Further, the recognition of the linear structure 42 is performed for every substrate, so the highly accurate positioning of the semiconductor element can be attained regardless of the shape of the linear structure 42.

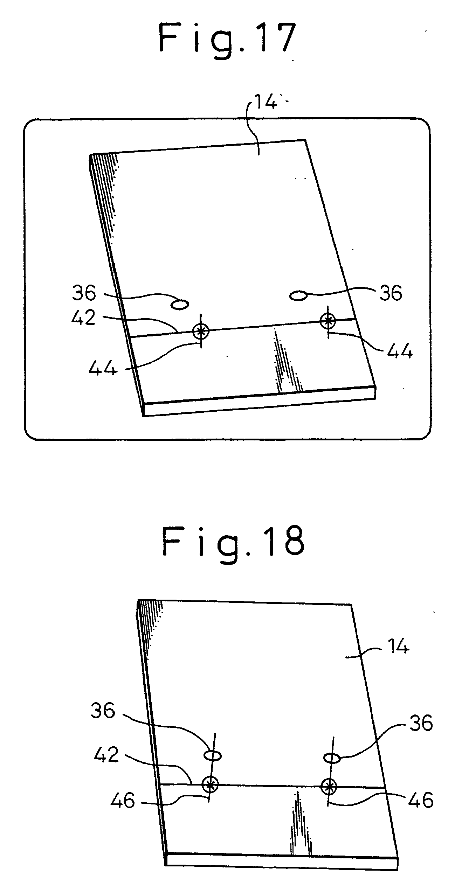

Figures 17 through 20 show examples of methods of recognizing the position of the linear structure 42.

In Fig. 17, the point of intersection between the linear structure 42 and the straight line 44 fixed on the screen is recognized.

In Fig. 18, the point of intersection between the linear structure 42 and the straight line 46 passing through the center of the circular positioning mark 36 is recognized.

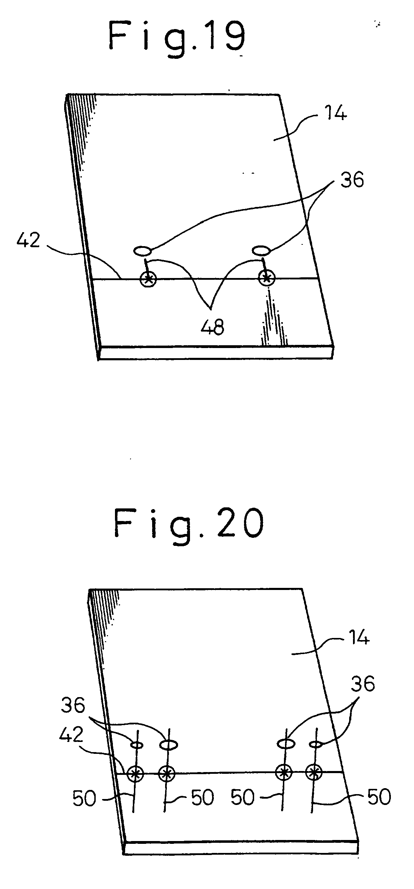

In Fig. 19, linear recognizing marks 48 are formed at positions where the linear recognizing marks 48 intersect with the linear structure 42, respectively. Thus, the point of intersection between the linear structure 42 and the linear recognizing mark 48 is recognized.

In Fig. 20, a plurality of recognizing marks 50, which are different in shape and position from one another, are formed. Further, the relative position between the linear structure 42 and each of the marks 50 is recognized. Furthermore, the recognized relative positions are averaged.

As described above, in embodiments of the present invention, the high-precision adjusting and positioning of semiconductor elements onto a substrate can be achieved in a short time. Further, a mark for adjusting is formed on the substrate and thus there is no necessity for providing a marking area in a small semiconductor element. Consequently, a load imposed on the semiconductor element is light. Moreover, even when the mark is hidden, an adjustment position can be checked.

**Claims**

1. An apparatus for assembling a semiconductor device, comprising:

   a stage (16) having a substrate support surface for supporting a substrate (14);
   a support member (18) for carrying a semiconductor element (12) to a position on or near a substrate (14) supported by said stage (16);
   a microscope unit (22) arranged at a first inclination angle of less than 90° with respect to the substrate support surface of said stage (16);
   a counter illuminating unit (24) arranged to an opposite side of a normal to the substrate support surface of said stage (16) to said microscope unit (22), and arranged at a second inclination angle of less than 90° with respect to the substrate support surface thereof;
   a camera (26) arranged at an image forming position of said microscope unit (22); and
   an image processing unit (28) connected to said camera (26),
   **characterised in that** the microscope unit (22) includes a coaxial illumination unit (20) arranged for illuminating a side surface of a semiconductor element (12) located on a substrate (14) supported by the support surface of the stage (16), the side surface extending in a direction outwardly from the support surface, the coaxial illumination unit (20) being arranged to output light in a direction coaxial with the microscope unit (22).

2. The apparatus for assembling a semiconductor device according to claim 1, wherein said stage (16) has a heater for enabling a semiconductor element (12) to be soldered to a substrate (14).

3. The apparatus for assembling a semiconductor device, according to claim 1, wherein such a substrate (14) carries at least one positioning mark (36), wherein said camera (26) is adapted to acquire an image (36a) of said at least one positioning mark (36) and an image (38a) of a reflection (38) of said at least one positioning mark reflected by such a side surface of said semiconductor element (12), thereby to obtain a positional relationship between the image (36a) of said at least one positioning mark (36) and the image (38a) of the reflection (38) of said at least one positioning mark (36), so as to enable positioning of said semiconductor element (12) onto said substrate (14) according to the positional relationship between the image (36a) of said at least one positioning mark (36), and the image (38a) of the reflection of said at least one positioning mark (36).

4. The apparatus for assembling a semiconductor device according to claim 3, further comprising:

   calculating means (32) for calculating a positional relationship between the substrate (14) and the semiconductor element (12) from the positional relationship between the image of said at least one positioning mark (36) and the image (38a) of the reflection thereof (38); and moving means (34) for moving at least one of said stage (16) and said support member (18) according to said calculating means (32).

5. The apparatus for assembling a semiconductor device according to claim 3, wherein said at least one positioning mark (36) has a circular shape.

6. The apparatus for assembling a semiconductor device according to claim 3, wherein said at least one positioning mark (36) has a specific shape formed on said substrate (14) .

7. The apparatus for assembling a semiconductor device according to claim 3, wherein said at least one positioning mark (36) is formed from a material which is different in reflectance from a material of said substrate (14).

8. The apparatus for assembling a semiconductor device according to claim 3, wherein said at least one positioning mark (36) comprises two positioning marks (36a, 36b).

9. The apparatus for assembling a semiconductor device according to claim 3, wherein said substrate (14) has a linear structure which is different from said at least one positioning mark (36).

**Patentansprüche**

1. Vorrichtung zum Zusammenbauen einer Halbleitervorrichtung mit

   einer Bühne (16) mit einer Substrattragefläche zum Tragen eines Substrats (14);

   einem Halteelement (18) zum Transportieren des Halbleiterelements (12) zu einer Position auf einem oder in der Nähe eines Substrats (14), das von der Bühne (16) getragen wird;

   einer Mikroskopeinheit (22), die in einem ersten Neigungswinkel von weniger als 90° in Bezug auf die Substrattragefläche der Bühne (16) angeordnet ist;

   einer Gegenbeleuchtungseinheit (24), die an einer der Mikroskopeinheit (22) gegenüberliegenden Seite einer Senkrechten zur Substrattragefläche der Bühne (16) und in einem zweiten Neigungswinkel von weniger als 90° in Bezug auf seine Substrattragefläche angeordnet ist;

   einer Kamera (26), die an einer Bilderzeugungsposition der Mikroskopeinheit (22) angeordnet ist; und

   einer Bildverarbeitungseinheit (28), die mit der Kamera (26) verbunden ist;

   **dadurch gekennzeichnet, dass** die Mikroskopeinheit (22) eine koaxiale Beleuchtungseinheit (20) aufweist, die zum Beleuchten einer Seitenfläche eines Halbleiterelements (12) angeordnet ist, das auf einem Substrat (14) angeordnet ist, das von der Tragefläche der Bühne (16) getragen wird, wobei sich die Seitenfläche in einer Richtung von der tragefläche nach außen erstreckt und die koaxiale Beleuchtungseinheit (20) so angeordnet ist, dass sie Licht in einer Richtung abgibt, die koaxial mit der Mikroskopeinheit (22) ist.

2. Vorrichtung zum Zusammenbauen einer Halbleitervorrichtung nach Anspruch 1, bei der die Bühne (16) eine Heizeinrichtung zum Ermöglichen eines Lötens eines Halbleiterelements (12) auf ein Substrat (14) aufweist.

3. Vorrichtung zum Zusammenbauen einer Halbleitervorrichtung nach Anspruch 1, bei der ein derartiges Substrat (14) mindestens eine Positionierungsmarkierung (36) aufweist, wobei die Kamera (26) zur Aufnahme eines Bilds (36a) der mindestens einen Positionierungsmarkierung (36) und eines Bilds (38a) einer Reflektion (38) der mindestens einen Positionierungsmarkierung geeignet ist, die von einer derartigen Seitenfläche des Halbleiterelements (12) reflektiert wird, wodurch eine Positionsbeziehung zwischen dem Bild (36a) der mindestens einen Positionierungsmarkierung (36) und dem Bild (38a) der Reflektion (38) der mindestens einen Positionierungsmarkierung (36) ermittelt wird, um eine Positionierung des Halbleiterelements (12) auf dem Substrat (14) nach Maßgabe der Positionsbeziehung zwischen dem Bild (36a) der mindestens einen Positionierungsmarkierung (36) und dem Bild (38a) der Reflektion der mindestens einen Positionierungsmarkierung (36) zu ermöglichen.

4. Vorrichtung zum Zusammenbauen einer Halbleitervorrichtung nach Anspruch 3, die ferner umfasst:

   eine Berechnungseinrichtung (32) zum Berechnen einer Positionsbeziehung zwischen dem Substrat (14) und dem Halbleiterelement (12) anhand der Positionsbeziehung zwischen dem Bild der mindestens einen Positionierungsmarkierung (36) und dem Bild (38a) ihrer Reflektion (38); und

   eine Bewegungseinrichtung (34) zum Bewegen von zumindest entweder der Bühne (16) oder dem Halteelement (18) nach Maßgabe der Berechnungseinrichtung (32).

5. Vorrichtung zum Zusammenbauen einer Halbleitervorrichtung nach Anspruch 3, bei der die mindestens eine Positionierungsmarkierung (36) kreisförmig ist.

6. Vorrichtung zum Zusammenbauen einer Halbleitervorrichtung nach Anspruch 3, bei der die mindestens eine Positionierungsmarkierung (36) eine spezifische Form aufweist, die auf dem Substrat (14) ausgebildet ist.

7. Vorrichtung zum Zusammenbauen einer Halbleitervorrichtung nach Anspruch 3, bei der die mindestens eine Positionierungsmarkierung (36) aus einem Material ausgebildet ist, das sich hinsichtlich des Reflektionsvermögens von einem Material des Substrats (14) unterscheidet.

8. Vorrichtung zum Zusammenbauen einer Halbleitervorrichtung nach Anspruch 3, bei der die mindestens eine Positionierungsmarkierung (36) zwei Positionierungsmarkierungen (36a, 36b) umfasst.

9. Vorrichtung zum Zusammenbauen einer Halbleitervorrichtung nach Anspruch 3, bei der das Substrat (14) eine lineare Struktur aufweist, die sich von der mindestens einen Positionierungsmarkierung (36) unterscheidet.

**Revendications**

1. Appareil d'assemblage d'un dispositif semi-conducteur, comprenant :

   un étage (16) ayant une surface de support de substrat destinée à supporter un substrat (14) ;
   un élément de support (18) destiné à acheminer un élément semi-conducteur (12) vers un emplacement situé sur ou près d'un substrat (14) supporté par ledit étage (16) ;
   une unité de microscope (22) agencée à un premier angle d'inclinaison inférieur à 90° par rapport à la surface de support de substrat dudit étage (16) ;
   une unité de rétroéclairage (24) agencée sur un côté opposé d'un plan normal par rapport à la surface de support de substrat dudit étage (16), en face de ladite unité de microscope (22), et agencée à un second angle d'inclinaison inférieur à 90° par rapport à la surface de support de substrat de celui-ci ;
   une caméra (26) agencée au niveau d'un emplacement de formation d'image de ladite unité de microscope (22) ; et
   une unité de traitement d'image (28) reliée à ladite caméra (26),
   **caractérisé en ce que** l'unité de microscope (22) comprend une unité d'éclairage coaxiale (20) agencée afin d'éclairer une surface latérale d'un élément semi-conducteur (12) situé sur un substrat (14) supporté par la surface de support de l'étage (16), la surface latérale s'étendant dans une direction allant vers l'extérieur depuis la surface de support, l'unité d'éclairage coaxiale (20) étant agencée afin de transmettre la lumière dans une direction coaxiale avec l'unité de microscope (22).

2. Appareil d'assemblage d'un dispositif semi-conducteur selon la revendication 1, dans lequel ledit étage (16) possède un réchauffeur permettant à un élément semi-conducteur (12) d'être brasé sur un substrat (14),

3. Appareil d'assemblage d'un dispositif semi-conducteur, selon la revendication 1, dans lequel ce substrat (14) porte au moins une marque de positionnement (36), dans lequel ladite caméra (26) est adaptée afin d'acquérir une image (36a) de ladite marque de positionnement au moins (36) et une image (38a) d'une réflexion (38) de ladite marque de positionnement au moins réfléchie par une surface latérale dudit élément semi-conducteur (12), afin d'obtenir ainsi une relation de position entre l'image (36a) de ladite marque de positionnement au moins (36) et l'image (38a) de la réflexion (38) de ladite marque de positionnement au moins (36), de façon à permettre le positionnement dudit élément semi-conducteur (12) sur ledit substrat (14) selon la relation de position entre l'image (36a) de ladite marque de positionnement au moins (36) et l'image (38a) de la réflexion de ladite marque de positionnement au moins (36).

4. Appareil d'assemblage d'un dispositif semi-conducteur selon la revendication 3, comprenant en outre :

   un moyen de calcul (32) destiné à calculer une relation de position entre le substrat (14) et l'élément semi-conducteur (12) à partir de la relation de position entre l'image de ladite marque de positionnement au moins (36) et l'image (38a) de la réflexion de celle-ci (38) ;
   et un moyen de déplacement (34) destiné à déplacer au moins l'un dudit étage (16) et dudit élément de support (18) selon ledit moyen de calcul (32).

5. Appareil d'assemblage d'un dispositif semi-conducteur selon la revendication 3, dans lequel ladite marque de positionnement au moins (36) possède une forme circulaire.

6. Appareil d'assemblage d'un dispositif semi-conducteur selon la revendication 3, dans lequel ladite marque de positionnement au moins (36) possède une forme spécifique formée sur ledit substrat (14).

7. Appareil d'assemblage d'un dispositif semi-conducteur selon la revendication 3, dans lequel ladite marque de positionnement au moins (36) est formée à partir d'un matériau qui est différent en termes de réflectance d'un matériau dudit substrat (14).

8. Appareil d'assemblage d'un dispositif semi-conducteur selon la revendication 3, dans lequel ladite marque de positionnement au moins (36) comprend deux marques de positionnement (36a, 36b).

9. Appareil d'assemblage d'un dispositif semi-conducteur selon la revendication 3, dans lequel ledit substrat (14) possède une structure linéaire qui est différente de ladite marque de positionnement au moins (36).

# Fig.1

# Fig.2

# Fig.3

# Fig. 4

# Fig. 5

# Fig.6

# Fig.7

# Fig. 8

# Fig. 9

# Fig.10

# Fig.11

# Fig.12

# Fig.13

# Fig.14

# Fig.15A

# Fig.15B

# Fig.15C

# Fig.16A

# Fig.16B

# Fig.16C

# Fig.17

# Fig.18

# Fig.19

# Fig.20

**EP 0 949 660 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3903363 A